# EUROPÄISCHE PATENTSCHRIFT

(11) **EP 3 864 710 B1**
(45) Veröffentlichungstag und Bekanntmachung des Hinweises auf die Patenterteilung: **31.08.2022**
(21) Anmeldenummer: 20734497.9
(22) Anmeldetag: 19.06.2020
(51) Int. Cl.: H01L 39/24

(54) **SUBELEMENT AUF BASIS VON NB-HALTIGEN STABELEMENTEN MIT PULVERGEFÜLLTEM KERNROHR FÜR EINEN NB3SN-HALTIGEN SUPRALEITERDRAHT UND ZUGEHÖRIGE HERSTELLUNGSVERFAHREN**
SUBELEMENT BASED ON NB-CONTAINING ROD ELEMENTS WITH POWDER-FILLED CORE TUBE FOR AN NB3SN-CONTAINING SUPERCONDUCTOR WIRE, AND ASSOCIATED PRODUCTION METHOD
SOUS-ÉLÉMENT BASÉ SUR DES BARRES CONTENANT DU NB AVEC UN TUBE CENTRAL REMPLI DE POUDRE POUR UN FIL SUPRACONDUCTEUR CONTENANT DU NB3SN ET PROCÉDÉ DE FABRICATION ASSOCIÉ

(30) Priorität: 25.06.2019 DE 102019209170
(43) Veröffentlichungstag der Anmeldung: 18.08.2021
(73) Patentinhaber: Bruker EAS GmbH, 63450 Hanau (DE)
(72) Erfinder: SCHLENGA, Klaus, 76149 Karlsruhe (DE); WANIOR, Matheus, 63571 Gelnhausen (DE); ABÄCHERLI, Vital, 63526 Erlensee (DE); THOENER, Manfred, 63599 Biebergemünd (DE); BÜHLER, Carl, 63505 Langenselbold (DE); SAILER, Bernd, 63755 Alzenau (DE)
(74) Vertreter: Kohler Schmid Möbus Patentanwälte
(86) Internationale Anmeldenummer: PCT/EP2020/067236
(87) Internationale Veröffentlichungsnummer: WO 2020/260169

(56) Entgegenhaltungen:
- US-A1- 2008 274 903
- US-A1- 2010 255 998
- US-A1- 2014 096 997
- US-A1- 2018 158 577

## Beschreibung

Die Erfindung betrifft ein Verfahren zur Herstellung eines Subelements für einen Nb₃Sn-haltigen Supraleiterdraht,
wobei das Subelement ausgebildet ist mit
- einem Sn-haltigen Kern,
- einer inneren Matrix, die Cu enthält und die den Sn-haltigen Kern umgibt,
- einen Bereich von aneinander anliegenden Nb-haltigen Stabelementen, der die innere Matrix umgibt, wobei die Nb-haltigen Stabelemente jeweils mit einem Nb-haltigen Kernfilament und einer Cu-haltigen Filamenthülle ausgebildet sind, insbesondere wobei die Nb-haltigen Stabelemente jeweils im Außenquerschnitt hexagonal ausgebildet sind,
- einer äußeren Matrix, die Cu enthält und den Bereich von Nb-haltigen Stabelementen umgibt.

Die Bereitstellung eines solchen Subelements ist bekannt geworden aus der EP 2 717 340 A2.

Supraleitermaterialien können praktisch ohne ohmsche Verluste elektrischen Strom tragen, und werden beispielsweise zum Bau von Magnetspulen eingesetzt, mit denen besonders große Magnetfeldstärken erzeugt werden können.

Ein wichtiges Supraleitermaterial, insbesondere für den Bau von Magnetspulen, ist Nb₃Sn. Da Nb₃Sn sich nicht plastisch verformen lässt, wird für die Herstellung eines Nb₃Sn-haltigen Supraleiterdrahts (auch kurz: Nb₃Sn-Supraleiterdraht) meist zunächst ein Vorleiter (auch genannt Subelement) gefertigt, der Nb und Sn enthält, typischerweise mit Cu als Matrixmaterial. Der Vorleiter wird durch querschnittsverjüngende Umformung und Bündelung mehrerer Subelemente zu einem Fertigleiter verarbeitet. Dieser Fertigleiter wird meist nochmals einer querschnittsverjüngenden Umformung unterzogen, und sodann in eine gewünschte Geometrie gebracht, etwa durch Wickeln einer Spule. Anschließend wird in einer Reaktions-Wärmebehandlung die supraleitende Nb₃Sn-Phase erzeugt, wodurch aus dem Fertigleiter der fertige Nb₃Sn-Supraleiterdraht entsteht. Die Herstellung eines Nb₃Sn-Supraleiterdrahts ist somit ein mehrstufiger und insgesamt schwieriger Prozess. Dabei haben sich mehrere Routen entwickelt, die im Vorgehen und in den für die Qualität des fertigen Nb₃Sn-Supraleiterdrahts relevanten, ablaufenden Reaktionen erhebliche Unterschiede aufweisen.

Bei der so genannten Bronze-Route wird das Sn, das mit dem Nb des Vorleiters reagieren soll, im Vorleiter über eine Bronze-Matrix zur Verfügung gestellt. Die Bronze-Route ist vergleichsweise einfach auszuführen, jedoch begrenzt der Sn-Gehalt der Bronze-Matrix die Entstehung der Nb₃Sn-Phase.

Bei der "internal tin" (Internes Zinn)-Route ist im Vorleiter üblicherweise zentral eine Zinnquelle angeordnet, wobei in der Reaktions-Wärmebehandlung das Sn aus dem Kern meist durch eine Cu Matrix hindurch mit dem Nb des Vorleiters reagiert. Im Falle eines Vorgehens nach dem "Powder in Tube"-Prinzip (abgekürzt PIT) wird dabei Sn-haltiges Pulver in einem Rohr aus Nb oder einer Nb-Legierung angeordnet. Das gefüllte Nb-Rohr wird in einer Cu-haltigen Umhüllung angeordnet, wodurch ein PIT-Element erhalten wird. Die PIT-Elemente werden gezogen und gebündelt. In der Reaktions-Wärmebehandlung reagiert das Sn im PIT-Kern direkt mit dem umhüllenden Nb-Rohr. Ein typischer PIT-Prozess ist beispielsweise durch die EP 3 062 359 B1 beschrieben. Der PIT-Prozess ist komplexer als die Bronze-Route, erzielt aber auch bessere Stromtragfähigkeiten.

Eine Variante eines PIT-Prozesses beschreibt die EP 2 779 258 B1, wobei anstelle des einen Nb-Rohrs ein äußeres Rohr aus Nb oder einer Nb-Legierung sowie ein inneres Rohr aus Nb oder einer Nb-Legierung verwendet wird. Das innere Rohr wird separat mit einem Sn- und Cu-haltigen Pulver befüllt und gezogen, wobei das enthaltene Pulver verdichtet wird. Anschließend wird das gezogene innere Rohr in das äußere Rohr eingesetzt.

Die "internal tin"-Route kann auch gemäß dem "Restack Rod Process" (abgekürzt RRP, "Umbündelung der Stäbe-Prozess")-Prinzip erfolgen. Hierbei wird eine Vielzahl von hexagonalen Nb-Filamenten (auch genannt Nb-haltige Stabelemente), typischerweise jeweils enthaltend einen Nb-Stab und eine umgebende Cu-Filamenthülle, ringartig gebündelt und innen und außen von einer Cu-Matrix umgeben. Im Inneren wird ein Zentrum enthaltend Sn angeordnet, und außen werden eine Diffusionsbarriere und eine Cu-Hülle angeordnet. Solchermaßen ausgebildete Subelemente werden auf einen hexagonalen Außenquerschnitt gezogen, gebündelt und zur Ausbildung eines Drahtes von einer Kupfermatrix umgeben, vgl. die US 7,585,377 B2. Mit dem RRP-Prozess können recht große supraleitende Stromtragfähigkeiten eines fertigen Nb₃Sn-Supraleiterdrahts erreicht werden.

Die EP 2 717 340 A2 beschreibt ein Halbzeug für einen Nb3Sn-Supraleiterdraht für einen RRP-Prozess, bei der Cu-haltige Filamenthüllen für die Nb-haltigen Stabelemente eingesetzt werden, die zusätzlich auch Sn-haltig sind. In einer Variante wird vorgeschlagen, die Sn-haltige Struktur, die zentral in der inneren Cu-Matrix angeordnet ist, durch Pulver aus elementarem Sn auszubilden, das in einer Bohrung der inneren Cu-haltigen Matrix enthalten ist.

Eine speziellere Variante eines Fertigleiters für einen Nb₃Sn-Supraleiterdrahts sieht die Bündelung von NbCu-Stäben und Cu-Stäben mit NaCI-Füllung in einem Cu-Mantel vor. Das NaCl wird mit Wasser ausgespült und durch Sn ersetzt, vgl. US 5,534,219 A.

In der WO 2015/175064 A2 werden Nb₃Sn-Supraleiterdrähte und zugehörige Herstellungsverfahren beschrieben, wobei während der Reaktions-Wärmebehandlung Metalloxid-Ausscheidungen gebildet werden. Ähnliche Nb₃Sn-Supraleiterdrähte beschreiben X. Xu et al. in "Internally Oxidized Nb3Sn Strands with Fine Grain Size and High Critical Current Density", Adv. Mater. 2015, 27, Seiten 1346-1350_{.} Weitere Beispiele vom Stand der Technik finden sich in US2018/158577, US2014/96997 und US2008/274903.

### Aufgabe der Erfindung

Es ist Aufgabe der Erfindung, ein Herstellungsverfahren für ein Subelement für einen Nb₃Sn-haltigen Supraleiterdraht zur Verfügung zu stellen, mit dem auf einfache und kostengünstige Weise eine verbesserte supraleitende Stromtragfähigkeit erreicht werden kann.

### Beschreibung der Erfindung

Diese Aufgabe wird erfindungsgemäß gelöst durch ein Verfahren der eingangs genannten Art, das dadurch gekennzeichnet ist,
dass der Sn-haltige Kern separat gefertigt wird, mit den Schritten
a) in ein Kernrohr wird ein Sn-haltiges Pulver eingefüllt,
b) das Kernrohr einschließlich des Sn-haltigen Pulvers wird einer querschnittsreduzierenden Umformung unterzogen, wobei das Sn-haltige Pulver des Sn-haltigen Kerns verdichtet wird,
und dass der separat gefertigte Sn-haltige Kern in eine Ausnehmung der inneren Matrix des Subelements eingesetzt wird.

Auf diese Weise können Subelemente auf einfache und kostengünstige Weise hergestellt werden, die eine hohe supraleitende Stromtragfähigkeit im fertigen Supraleiterdraht aufweisen. Um die äußere Matrix herum kann eine Diffusionsbarriere angeordnet sein bzw. werden.

Durch das erfindungsgemäße Verfahren kann ein Subelement erhalten werden, bei dem der Sn-haltige Kern ein Kernrohr umfasst, in das ein Sn-haltiges Pulver eingefüllt ist, wobei das Sn-haltige Pulver in einem verdichteteten Zustand ist.

Infolge des erfindungsgemäßen Verfahrens weist das Sn-haltige Pulver im Sn-haltigen Kern ein Pressgefüge auf, welches durch die querschnittsreduzierende Umformung des befüllten Kernrohrs erhalten wird. Mit anderen Worten, das Sn-haltige Pulver ist im Wesentlichen in radialer Richtung verpresst, insbesondere durch ein vorab erfolgtes Ziehen, Walzen, Pressen oder Extrudieren des mit dem Sn-haltigen Pulver gefüllten Kernrohrs. Das Pressgefüge kann beispielsweise durch die Ausrichtung der Pulverkörner und deren Spannungszustand festgestellt werden, etwa im Querschliff und/oder durch Röntgenbeugungs-Messung. Durch die querschnittsreduzierende Umformung kann auf einfache Weise eine Verdichtung des Sn-haltigen Pulvers erreicht werden; diese Verdichtung ist zudem im Vergleich zu axialen Pressverfahren sehr gleichmäßig und auch über größere axiale Längen problemlos durchzuführen.

Die Erfindung sieht vor, ein Subelement für einen RRP-Prozess mit einem Sn-haltigen Kern auszustatten, der auf einem verdichteten Sn-haltigen Pulver basiert. Durch die Verwendung eines Sn-haltigen Pulvers kann die Zusammensetzung des Sn-haltigen Kerns, insbesondere die Verteilung der elementaren Anteile von Sn und anderen Elementen, insbesondere Metallen wie Cu, auf einfache Weise eingestellt und an eine gewünschte Anwendung angepasst werden; insbesondere ist es nicht nötig, teure Sn-haltige Kernstäbe unterschiedlicher Zusammensetzung für unterschiedliche Anwendungen zu produzieren. Dadurch kann eine Optimierung der Bildung der supraleitenden Phase (Nb₃Sn) in einer Reaktionswärmebehandlung (auch genannt Reaktionsglühen), und damit eine Optimierung der Stromtragfähigkeit des fertigen Supraleiterdrahts, auf einfache und kostengünstige Weise erfolgen. Durch die Einstellung der Zusammensetzung des Sn-haltigen Kerns bzw. des Sn-haltigen Pulvers kann im fertigen Supraleiterdraht die Stromtragfähigkeit (kritische Stromdichte) der wichtigen so genannten feinkörnigen Nb₃Sn-Fraktion (fine grained Nb₃Sn fraction) erhöht werden.

Durch die erfindungsgemäß vorgesehene Verdichtung des Sn-haltigen Pulvers kann nicht nur ein besonders hoher Anteil an supraleitender Phase im Querschnitt des supraleitenden Drahtes erhalten werden, sondern auch die Diffusion von Sn aus dem Sn-haltigen Kern in den Bereich der Nb-haltigen Stabelemente verbessert und insgesamt die Effizienz der Bildung von Nb₃Sn verbessert werden. Insbesondere kann der Sn-Anteil in der feinkörnigen Nb₃Sn-Fraktion als auch der Anteil der feinkörnigen Fraktion selbst weiter erhöht werden, was die Stromtragfähigkeit (kritische Stromdichte integriert über den Drahtquerschnitt) des fertigen Supraleiterdrahts insgesamt steigert, wobei gleichzeitig durch die auf einfache Weise einstellbare Zusammensetzung auch die kritische Stromdichte dieser Fraktion hoch gehalten werden kann.

Bei Supraleiterdrähten basierend auf herkömmlichen PIT-Subelementen wird meist ein geringerer Anteil der wichtigen feinkörniger Nb₃Sn-Fraktion im Vergleich zu RRP-basierten Supraleiterdrähten erhalten. Im Rahmen der Erfindung wird zumindest ein überwiegender Teil des Nb zur Bildung der Nb₃Sn-Phase durch die Nb-haltigen Stabelemente beigesteuert. Ein teures Nb-Rohr als Hauptquelle für Nb, wie es im PIT-Verfahren benötigt wird, ist nicht erforderlich. Im Bereich der Nb-haltigen Stabelemente als Nb-Quelle ist die Diffusion von Sn im Vergleich zu einem Nb-Rohr als Nb-Quelle erleichtert, da die Cu-haltigen Filamenthüllen ein Netzwerk an schnellen Diffusionspfaden zur Verfügung stellen; über diese können auch radial weiter außen liegende Bereiche des Subelements gut vom Sn aus dem verdichteten Pulverkern erreicht werden. Dadurch kann der Anteil (Volumenanteil) von feinkörniger Nb₃Sn-Fraktion im fertigen Supraleiterdraht erhöht werden, was die supraleitende Stromtragfähigkeit (kritischer Strom integriert über den Drahtquerschnitt) des fertigen supraleitenden Drahts verbessert.

Da gleichzeitig über die Verwendung des verdichteten Sn-haltigen Pulvers als Sn-Quelle auch die supraleitfähige Stromtragfähigkeit (kritische Stromdichte) des der feinkörnigen Nb₃Sn-Fraktion und dessen Anteil im fertigen Gefüge erhöht werden kann, wird durch die erfindungsgemäße Kombination von Maßnahmen eine Verbesserung der Stromtragfähigkeit des fertigen Supraleiterdrahts insgesamt erhalten, die weit über die zu erwartenden Effekte der Einzelmaßnahmen hinaus geht.

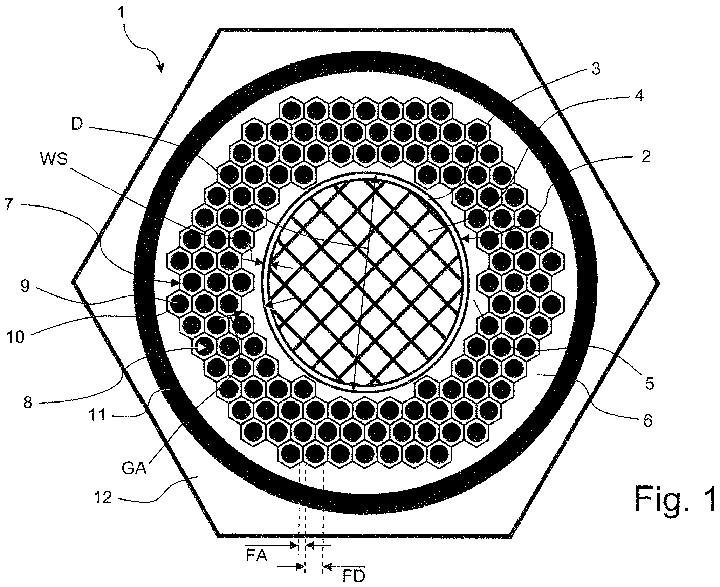

Besonders gute Stromtragfähigkeiten können erzielt werden, wenn im Subelement die Wandstärke WS des Kernrohrs klein ist im Verhältnis zum Durchmesser D des Kernrohrs, etwa mit WS≤0,15^{∗}D, bevorzugt WS≤0,10^{∗}D, und/oder wenn der größte radiale Abstand GA zwischen dem Kernrohr und der Innenseite des Bereichs der Nb-haltigen Stabelemente der inneren Matrix klein ist im Verhältnis zum Durchmesser D des Kernrohrs, etwa mit GA≤0,30^{∗}D, bevorzugt GA ≤0,20^{∗}D, besonders bevorzugt GA≤0,10^{∗}D, und/oder wenn der Abstand FA (kleinster Abstand von Außenseite zu Außenseite) zwischen den Nb-haltigen Kernfilamenten klein ist im Verhältnis zum Durchmesser FD der Nb-haltigen Kernfilamente, etwa mit FA≤0,30^{∗}FD, bevorzugt FA≤0,20^{∗}FD, besonders bevorzugt FA≤0,15^{∗}FD, ganz besonders bevorzugt FA≤0,10^{∗}FD (vgl. dazu auch Fig. 1 unten). Alle drei Maßnahmen tragen jeweils für sich und bevorzugt in Kombination dazu bei, die Diffusion von Sn aus dem Sn-haltigen Kern, insbesondere aus dem verdichteten Sn-haltigen Pulver, in die Nb-haltigen Kernfilamente zu verbessern und zu vergleichmäßigen, was wiederum einen noch größeren Anteil von feinkörniger Nb₃Sn-Fraktion mit weiter verbesserter Stromtragfähigkeit ermöglicht.

Das verdichtete Sn-haltige Pulver im Kernrohr weist typischerweise mindestens 25%, bevorzugt mindestens 40%, und besonders bevorzugt mindestens 50%, der theoretischen Dichte auf. Der Sn-Gehalt (unabhängig von der chemischen Form des Sn, insbesondere einschließlich elementarem Sn, in Legierung enthaltenem Sn und in intermetallischen Phasen gebundenes Sn) des Sn-haltigen Pulver beträgt typischerweise wenigstens 40 Gew%, bevorzugt wenigstens 50 Gew%, und besonders bevorzugt wenigstens 60 Gew%.

### Bevorzugte Varianten des erfindunasaemäßen Verfahrens

Bei einer bevorzugten Variante des erfindungsgemäßen Herstellungsverfahrens wird das Verfahren so geführt, dass im erhaltenen Subelement für eine Wandstärke WS des Kernrohrs und einen Durchmesser D des Kernrohrs gilt: WS≤0,15^{∗}D, bevorzugt WS≤0,10^{∗}D.

Bevorzugt ist auch eine Verfahrensvariante, bei der das Sn-haltige Pulver eine Pulvermischung ist, welche Sn in wenigstens zwei verschiedenen chemischen Formen enthält,
insbesondere wobei das Sn-haltige Pulver Sn in wenigstens zwei der folgenden chemischen Formen enthält:
- elementares Sn,
- eine oder mehrere unterschiedlich zusammengesetzte intermetallische Phasen oder Legierungen von Nb und Sn, bevorzugt NbSn₂ und/oder Nb₆Sn₅,
- eine oder mehrere unterschiedlich zusammengesetzte intermetallische Phasen oder Legierungen von Cu und Sn,
- eine oder mehrere unterschiedlich zusammengesetzte intermetallische Phasen oder Legierungen von Sn und Ti;
- eine oder mehrere unterschiedlich zusammengesetzte intermetallische Phasen oder Legierungen von Sn und Ta. Dies vereinfacht die Einstellung des Sn-Anteiles im Sn-haltigen Pulver bei gleichzeitiger Einstellung der Anteile anderer Elemente. Zusätzlich zu Sn enthaltene Elemente im Sn-haltigen Kern können insbesondere zur Verbesserung der Umformeigenschaften, zur Verbesserung des Diffusionsverhaltens oder auch zur Verbesserung der Stromtragfähigkeit (etwa durch Bildung von ternären Phasen oder Pinningzentren, oder allgemein durch Einstellung des Gefüges) beitragen.

Vorteilhaft ist eine Variante, bei der das Sn-haltige Pulver eine Pulvermischung ist, welche einen Cu-haltigen Pulveranteil enthält,
insbesondere wobei der Cu-haltige Pulveranteil elementares Cu umfasst. Durch einen Cu-Anteil lassen sich die Umformungseigenschaften des Subelements bzw. des Kerns verbessern, insbesondere wenn elementares Cu im Pulver enthalten ist. Mittels Cu kann auch eine Diffusionsbeschleunigung des Sn zu den Nb-haltigen Stabelementen während der Reaktions-Wärmebehandlung erreicht werden.

Bei einer bevorzugten Variante ist das Kernrohr Cu-haltig,
insbesondere mit wenigstens 25 Gew% Cu, bevorzugt mit wenigstens 50 Gew% Cu. Das Cu-haltige Kernrohr weist gute Umformeigenschaften für eine querschnittsreduzierende Umformung auf; zudem kann das enthaltene Cu zur Verbesserung der Sn-Diffusion aus dem Kern zu den Nb-haltigen Stabelementen beitragen.

Besonders bevorzugt ist eine Variante, bei der das Kernrohr Nb-haltig ist, insbesondere mit wenigstens 50 Gew% Nb, bevorzugt mit wenigstens 75 Gew% Nb. Durch ein Nb-haltiges Kernrohr kann während der Reaktions-Wärmebehandlung am Kernrohr zunächst eine Nb-haltige Phase mit hohem Sn-Anteil, insbesondere NbSn2, gebildet werden; im Übrigen wird die Sn-Diffusion nach weiter außen zunächst blockiert. Bei höherer Temperatur zerfällt die Nb-haltige Phase mit hohem Sn-Anteil dann in Sn und Nb₃Sn, wodurch relativ nahe an den Nb-haltigen Stabelementen eine Sn-Quelle zu einem späten Zeitpunkt der Reaktions-Wärmebehandlung zur Verfügung gestellt wird. Dadurch lässt sich ein besonders feines und gleichmäßiges Nb₃Sn-Gefüge erreichen (hoher Anteil der feinkörnigen Nb₃Sn-Fraktion), was die supraleitende Stromtragfähigkeit erhöht. Zudem kann der Flächenanteil des Subelements, in welchem Nb₃Sn gebildet wird, erhöht werden. Beides trägt zu einer hohen supraleitenden Stromtragfähigkeit bei. Das Kernrohr wird bei dieser Variante typischerweise mit einer Wandstärke WS gewählt, die im Vergleich zum Durchmesser D des Kernrohrs nicht zu klein gewählt ist, etwa mit WS≥0,01^{∗}D oder auch WS≥0,02^{∗}D. Im Rahmen der Erfindung kann insbesondere auch ein Kernrohr aus einer Nb-Cu-Legierung eingesetzt werden, bevorzugt mit einem Anteil von wenigstens 50 Gew% Nb und einem Anteil von wenigstens 25 Gew% Cu.

Bevorzugt ist weiterhin eine Variante, die vorsieht, dass
- zumindest ein Teil der Nb-haltigen Stabelemente des Bereich von aneinander anliegenden Nb-haltigen Stabelementen mit einem Nb-haltigen Kernfilament ausgebildet ist, das zusätzlich zu Nb auch Ti, Ta, Hf und/oder Zr enthält, und/oder
- in den Bereich von aneinander anliegenden Nb-haltigen Stabelementen Zusatz-Stabelemente untergemischt sind, die Ti, Ta, Hf und/oder Zr enthalten. Durch Zulegieren von Ta, Ti, Hf und/oder Zr im durch die Reaktions-Wärmebehandlung entstehenden Nb₃Sn kann die Stromtragfähigkeit des fertigen Supraleiterdrahts erhöht werden (Bildung einer ternären Phase). Die Verwendung von "Dotierstäben" ermöglicht die gezielte Einbringung der Elemente Ta, Ti, Hf und/oder Zr besonders nahe an den Orten, an denen auch das Nb₃Sn gebildet wird. Wenn Nb-haltige Stabelemente mit einem Kernfilament, dem Ti/Ta/Hf/Zr zulegiert ist, verwendet werden, sind typischerweise nur einzelne Nb-haltige Stabelemente des Subelements mit einem solchen Nb-haltigen Kernfilament ausgebildet, dem Ti/Ta/Hf/Zr zulegiert ist; alternativ können aber auch alle Nb-haltigen Stabelemente mit einem Nb-haltigen Kernfilament ausgebildet sein, dem Ti/Ta/Hf/Zr zulegiert ist. Wenn Zusatz-Stabelemente untergemischt werden, enthalten diese meist kein Nb (es ist aber auch möglich, die Zusatz-Stabelemente mit einem Nbanteil auszubilden). Die Zusatz-Stabelemente können von homogener Zusammensetzung (weisen also kein Kernfilament und keine Filamenthülle auf) sein oder sind von einer Cu oder Cu-haltigen Umhüllung umgeben.

Bevorzugt ist weiterhin eine Variante, bei der das Sn-haltige Pulver eine Pulvermischung ist, welche einen Pulveranteil enthält, der Ta-haltig und/oder Ti-haltig und/oder Hf-haltig und/oder Zr-haltig ist. Durch Zulegieren von Ta, Ti, Hf und/oder Zr im durch die Reaktions-Wärmebehandlung entstehenden Nb₃Sn kann die Stromtragfähigkeit des fertigen Supraleiterdrahts erhöht werden (ternäre Phase). Das Einbringen von Ta, Ti, Hf und/oder Zr als Pulveranteil im Sn-haltigen Pulver des Kerns ist besonders einfach. Insbesondere werden keine "Dotierstäbe" benötigt, die (nach Abgabe von Ta/Ti/Hf/Zr) selbst kein Nb₃Sn mehr bilden können. Des Weiteren kann auf diesem Weg die Sn-Diffusion während der Reaktions-Wärmebehandlung erhöht werden, was sich positiv auf die supraleitenden Eigenschaften auswirkt.

Bei einer vorteilhaften Variante ist vorgesehen,
dass der Bereich von aneinander anliegenden Nb-haltigen Stabelementen auch wenigstens eine Legierungskomponente X enthält,
dass das Sn-haltige Pulver auch wenigstens eine Partnerkomponente Pk enthält, insbesondere wobei das Sn-haltige Pulver eine Pulvermischung ist, welche einen Pulveranteil enthält, der die Partnerkomponente Pk enthält,
und dass die Legierungskomponente X und die Partnerkomponente Pk so gewählt und angeordnet sind, dass sie bei einer Reaktions-Wärmebehandlung des Subelements, bei dem Sn aus dem Sn-haltigen Kern und Nb aus den Nb-haltigen Stabelementen zu Nb₃Sn reagieren, Ausscheidungen XPk bilden können. Durch die Bildung der Ausscheidungen XPk können Pinning-Zentren geschaffen werden, mit denen die Stromtragfähigkeit (kritische Stromdichte) der supraleitenden Phase erhöht werden kann. XPk steht hier stellvertretend für alle stöchiometrischen Verhältnisse von X und Pk in den Ausscheidungen. Eine typische Reaktions-Wärmebehandlung zur Bildung von Nb₃Sn umfasst eine Temperaturerhöhung, ggf. mit Zwischenplateaus, auf eine maximale Temperatur von 600°C-800°C.

Bevorzugt ist eine Weiterentwicklung dieser Variante, bei der die wenigstens eine Partnerkomponente Pk Sauerstoff umfasst. Die Bereitstellung von Sauerstoff im Kern und die Bildung von oxidischen Ausscheidungen im Nb₃Sn-Gefüge ist besonders einfach möglich; insbesondere können die Legierungskomponente X und die Partnerkomponente Pk im Sn-haltigen Kern bzw. Pulverkern in der Regel ohne Beeinträchtigung der Umformeigenschaften des Subelements zur Verfügung gestellt werden. Alternativ oder zusätzlich zu Sauerstoff (O) können als Partnerkomponente Pk auch Schwefel (etwa zur Bildung von ZnS), Silizium (etwa zur Bildung von Ca₂Si), Kohlenstoff (etwa zur Bildung von Fe₃C) oder ein Halogen wie Chlor oder Fluor (etwa zur Bildung CaF₂) eingesetzt werden, mit denen nicht-oxidische Ausscheidungen gebildet werden können.

Bevorzugt ist bei dieser Weiterentwicklung vorgesehen, dass das Sn-haltige Pulver einen Pk-haltigen Pulveranteil enthält, wobei der Pk-haltige Pulveranteil ein Metalloxid umfasst, das durch die Legierungskomponente X reduziert werden kann, insbesondere wobei das Metall des Metalloxids Sn, Cu, Zn, Nb, Fe, Ni, Cr, Co und/oder W umfasst und/oder das Metalloxid SnO₂, Cu₂O, CuO, ZnO, Ag₂O und/oder Nb₂O₅ umfasst. Diese Materialsysteme zeigen eine gute Verbesserung der supraleitenden Stromtragfähigkeit, und sind einfach einzusetzen und kostengünstig. Typischerweise weist das Metalloxid ein geringeres Oxidationspotential als NbO₂ auf.

Bei einer bevorzugten Weiterentwicklung umfasst die Legierungskomponente X ein Metall, das unedler als Nb ist, insbesondere wobei die Legierungskomponente X dabei Zr, AI, Ti, Hf und/oder Be umfasst. Diese Legierungskomponenten sind einfach zu handhaben, und bilden effektive Ausscheidungen zur Verbesserung der Stromtragfähigkeit des Supraleiterdrahts.

Bei einer weiteren, bevorzugten Weiterentwicklung ist die Legierungskomponente X in den Nb-haltigen Kernfilamenten zumindest in einem Teil der Nb-haltigen Stabelemente enthalten. Dies ist einfach einzurichten und lässt die Ausscheidungen am gewünschten Ort im Nb₃Sn-Gefüge entstehen.

Vorteilhaft ist weiterhin eine Variante des erfindungsgemäßen Herstellungsverfahrens, bei der das Subelement weiterhin umfasst
- eine Diffusionsbarriere, die die äußere Matrix umgibt, insbesondere wobei die Diffusionsbarriere mindestens eines der Elemente Nb, Ta und/oder V enthält, und
- eine Hüllstruktur, die Cu enthält und die die Diffusionsbarriere umgibt, insbesondere wobei die Hüllstruktur einen hexagonalen Außenquerschnitt aufweist. Die Diffusionsbarriere behindert bzw. verhindert eine Diffusion von Sn radial nach außen in die Hüllstruktur hinein. Dadurch wird sichergestellt, dass die Hüllstruktur eine hohe (normalleitende) elektrische Leitfähigkeit nach der Reaktions-Wärmebehandlung behält, was den Supraleiterdraht im Betrieb stabilisiert und schützt. Bevorzugt ist die Diffusionsbarriere mit wenigstens 50 Gew% Nb, Ta und/oder V ausgebildet. Die Hüllstruktur weist bevorzugt den hexagonalen Außenquerschnitt auf, bevor das (vollständig zusammengesetzte) Subelement erstmals einer querschnittsverringernden Umformung unterzogen wird.

Eine Variante des erfindungsgemäßen Verfahrens sieht vor, dass das Verfahren so geführt wird, dass im erhaltenen Subelement für einen größten radialen Abstand GA zwischen dem Kernrohr und der Innenseite des Bereichs der Nb-haltigen Stabelemente der inneren Matrix und einen Durchmesser D des Kernrohrs gilt:
GA≤0,30^{∗}D, bevorzugt GA≤0,20^{∗}D, besonders bevorzugt GA≤0,10^{∗}D.

Weiterhin sieht eine Variante des erfindungsgemäßen Verfahrens vor, dass das Verfahren so geführt wird, dass im erhaltenen Subelement für einen kleinsten Abstand FA von Außenseite zu Außenseite zwischen den Nb-haltigen Kernfilamenten und einem Durchmesser FD der Nb-haltigen Kernfilamente gilt: FA≤0,30^{∗}FD, bevorzugt FA≤0,20^{∗}FD, besonders bevorzugt FA≤0,15^{∗}FD, ganz besonders bevorzugt FA≤0,10^{∗}FD.

Eine bevorzugte Variante des erfindungsgemäßen Verfahrens sieht vor,
dass ein Hauptkörper des Subelements, der die innere Matrix mit der Ausnehmung, den Bereich von aneinander anliegenden Nb-haltigen Stabelementen und die äußere Matrix umfasst, separat gefertigt wird, mit den Schritten
a') um eine ein- oder mehrteilige Innenstruktur, die Cu enthält, werden die Nb-haltigen Stabelemente angeordnet, und um die Nb-haltigen Stabelemente wird mindestens eine Außenstruktur, die Cu enthält, angeordnet, wodurch ein Zwischenkörper erhalten wird,
b') der Zwischenkörper wird einer querschnittsreduzierenden Umformung unterzogen, und
c') in die querschnittsreduzierte Innenstruktur wird eine Ausnehmung eingebracht, wodurch die innere Matrix mit der Ausnehmung und insgesamt der Hauptkörper erhalten wird. Durch dieses Vorgehen kann auf einfache und kostengünstige Weise ein Hauptkörper separat gefertigt werden, in den dann der ebenfalls separat gefertigte Sn-haltige Kern eingesetzt werden kann. Die Unterschritte des Schritts a') können in beliebiger Reihenfolge stattfinden. Die (durchgehende) Ausnehmung in der Innenstruktur wird typischerweise durch Bohren eingebracht. Zusätzlich zur Außenstruktur (etwa Außenrohr), die Cu enthält, kann zwischen der Außenstruktur und den Nb-haltigen Stabelementen ein Barrierenrohr eingefügt werden. Alternativ zu einem Barrierenrohr kann auch zu einem Rohr gewickeltes Barrienblech eingesetzt werden. Die Innenstruktur kann am Einfachsten als ein einteiliger Stab ausgebildet sein; die Innenstruktur kann aber auch aus Teilelementen, insbesondere einem Bündel von hexagonalen Teilelementen oder einem Bündel von sektorförmigen Teilelementen, zusammengesetzt sein. Falls gewünscht, kann der Hauptkörper mit einer Diffusionsbarriere und einer diese umgebenden Hüllstruktur gefertigt werden. Dazu kann beispielsweise der Zwischenkörper im Rahmen von Schritt a') mit einem (noch unverformten) Diffusionsbarriere-Vorrohr und einem (noch unverformten) Hüllstruktur-Vorrohr gefertigt werden. Alternativ kann beispielsweise auch nach Schritt b') die Diffusionsbarriere und die Hüllstruktur auf den querschnittsreduzierten Zwischenkörper aufgesetzt werden.

Ebenfalls in den Rahmen der vorliegenden Erfindung fällt ein Verfahren zur Herstellung eines Nb₃Sn-haltigen Supraleiterdrahts, umfassend folgende Schritte:
- mehrere Subelemente werden nach einem oben beschriebenen, erfindungsgemäßen Verfahren gefertigt;
- die gefertigten Subelemente werden einer querschnittsreduzierenden Umformung unterzogen;
- die umgeformten Subelemente werden zu einer Fertigleiter-Anordnung gebündelt, wobei mehrere umgeformte Subelemente aneinander gelegt werden und von einer Cu-haltigen Drahtaußenstruktur umschlossen werden;
- die Fertigleiter-Anordnung wird einer querschnittsreduzierenden Umformung unterzogen;
- die umgeformte Fertigleiter-Anordnung wird in eine gewünschte geometrische Form gebracht, insbesondere zu einer Spule gewickelt;
- die in Form gebrachte Fertigleiter-Anordnung wird einer Reaktions-Wärmebehandlung unterzogen, bei der das Nb und das Sn aus den Subelementen zu Nb₃Sn reagieren. Mit diesem Verfahren kann ein Nb₃Sn-haltiger Supraleiterdraht mit hoher Stromtragfähigkeit auf einfache und kostengünstige Weise erhalten werden.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

- Fig. 1: zeigt im schematischen Querschnitt eine erste Bauform eines Subelements, das im Rahmen der Erfindung hergestellt werden kann;
- Fig. 2: zeigt im schematischen Querschnitt eine zweite Bauform eines Subelements, das im Rahmen der Erfindung hergestellt werden kann, wobei unter die Nb-haltigen Stabelemente Zusatz-Stabelemente untergemischt sind, die Ta enthalten;
- Fig. 3: zeigt im schematischen Querschnitt eine dritte Bauform eines Subelements, das im Rahmen der Erfindung hergestellt werden kann, wobei ein Teil der Nb-haltigen Stabelemente mit einem Nb-haltigen Kernfilament ausgebildet ist, das zusätzlich Ta enthält;
- Fig. 4: illustriert schematisch eine Variante eines erfindungsgemäßen Verfahrens zur Herstellung eines Subelements;
- Fig. 5: illustriert schematisch eine Variante eines erfindungsgemäßen Verfahrens zur Herstellung eines Nb₃Sn-haltigen Supraleiterdrahts;
- Fig. 6: illustriert schematisch eine Abwandlung der in Fig. 4 gezeigten Variante zur Herstellung eines Subelements, unter Nutzung einer mehrteiligen Innenstruktur für den Hauptkörper.

Die **Fig. 1** zeigt in einem schematischen Querschnitt eine erste Bauform eines Subelements 1 (auch genannt Vorleiter), der für die Herstellung eines Nb₃Sn-haltigen Supraleiterdrahts eingesetzt werden kann. Das Subelement 1 kann im Rahmen des erfindungsgemäßen Verfahrens hergestellt werden.

Das Subelement 1 umfasst einen Sn-haltigen Kern 2, der durch ein Kernrohr 3, hier gefertigt aus einer Legierung enthaltend ca. 53 Gew% Nb und ca. 47 Gew% Ti, sowie ein in das Kernrohr 3 eingefülltes, Sn-haltiges Pulver 4 ("Pulverkern") ausgebildet ist. In einer alternativen Bauform kann das Kernrohr 3 auch aus elementarem Cu gefertigt sein.

Das Sn-haltige Pulver 4 ist hier eine Pulvermischung aus elementarem Sn-Pulver, elementarem Cu-Pulver, NbSn₂-Pulver, SnTi₂-Pulver sowie CuO-Pulver. Der Gesamtgehalt an Sn (aus dem elementarem Sn-Pulver, dem NbSn₂-Pulver und dem SnTi₂-Pulver) in der Pulvermischung beträgt hier ca. 60 Gew%.

Die Wandstärke WS des Kernrohrs 3 ist klein im Verhältnis zum Durchmesser D des Kernrohrs 3, hier mit ca. WS=0,03^{∗}D; allgemein bevorzugt ist WS≤0,15^{∗}D oder auch WS≤0,10^{∗}D oder sogar WS≤0,05^{∗}D.

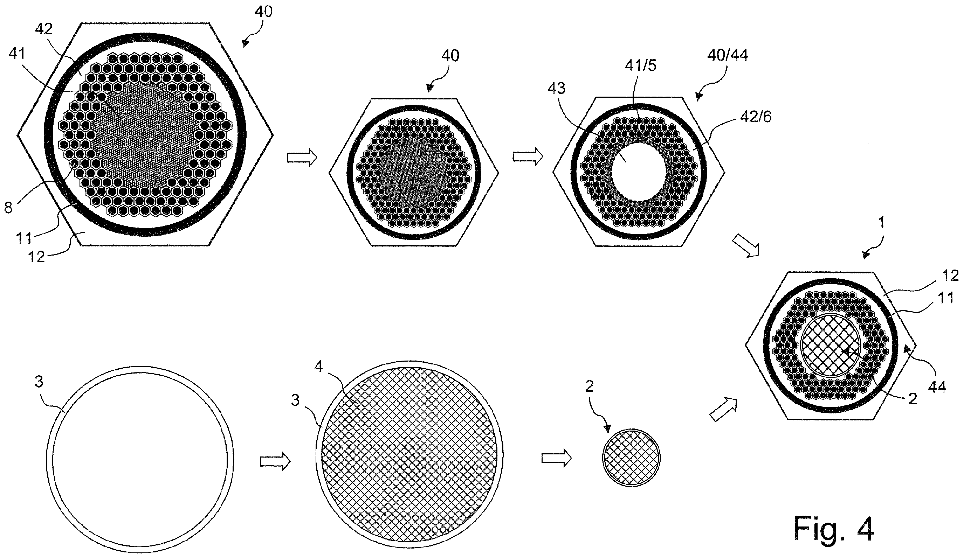

Das Sn-haltige Pulver 4 liegt im Kernrohr 3 in einem verdichteten Zustand vor, hier resultierend aus einer vorangegangene querschnittsverkleinernden Umformung des befüllten Kernrohrs 3 (vgl. hierzu Fig. 4). Das Sn-haltige Pulver ist hier auf ca. 50% seiner theoretischen Dichte verdichtet worden, und enthält also noch einen Anteil von Leerräumen ("Poren").

Der Sn-haltige Kern 2 ist von einer inneren Matrix 5 umgeben, die hier aus elementarem Cu gefertigt ist. Zwischen der inneren Matrix 5 und einer äußeren Matrix 6, die hier ebenfalls aus elementarem Cu besteht, liegt ein ringförmiger Bereich 7 von aneinander anliegenden Nb-haltigen Stabelementen 8. Jedes der Nb-haltigen Stabelemente 8 umfasst ein Nb-haltiges Kernfilament 9 und eine Cu-haltige Filamenthülle 10, die das Nb-haltige Kernfilament 9 umgibt.

Die Nb-haltigen Kernfilamente 9 bestehen hier aus einer Legierung von Nb und Hf. Diese Legierung besteht ganz überwiegend aus Nb; der Hf-Anteil liegt dabei bei 1 Gew% oder weniger. Die Cu-haltigen Filamenthüllen 10 bestehen hier aus elementarem Cu; alternativ kann auch ein gewisser Anteil Sn in den Cu-haltigen Filamenthüllen 10 vorgesehen sein. Die Nb-haltigen Stabelemente 8 weisen hier einen hexagonalen Außenquerschnitt auf.

Der größte radiale Abstand GA zwischen der Außenseite des Kernrohrs 3 und der Innenseite des Bereichs 7 der Nb-haltigen Stablemente 8, also die größte radiale Wandstärke der inneren Matrix 5, ist ebenfalls klein im Verhältnis zum Durchmesser D des Kernrohrs 3, hier mit ca. GA=0,10^{∗}D; allgemein bevorzugt ist GA≤0,30^{∗}D oder auch GA≤0,20^{∗}D.

Weiterhin ist im gezeigten Querschnitt der kleinste Abstand FA zwischen den Nb-haltigen Kernfilamenten 9 klein im Verhältnis zum Durchmesser FD der Nb-haltigen Kernfilamente 9, hier mit ca. FA=0,30^{∗}FD; allgemein bevorzugt ist FA≤0,30^{∗}FD oder auch FA≤0,20^{∗}FD oder auch FA≤0,15^{∗}FD oder sogar FA≤0,10^{∗}FD.

Um die äußere Matrix 6 ist in der gezeigten Bauform eine rohrförmige Diffusionsbarriere 11 angeordnet, die hier aus elementarem Nb gefertigt ist. Die Diffusionsbarriere 11 ist wiederum umgeben von einer Hüllstruktur 12, die hier aus elementarem Cu gefertigt ist und einen hexagonalen Außenquerschnitt aufweist.

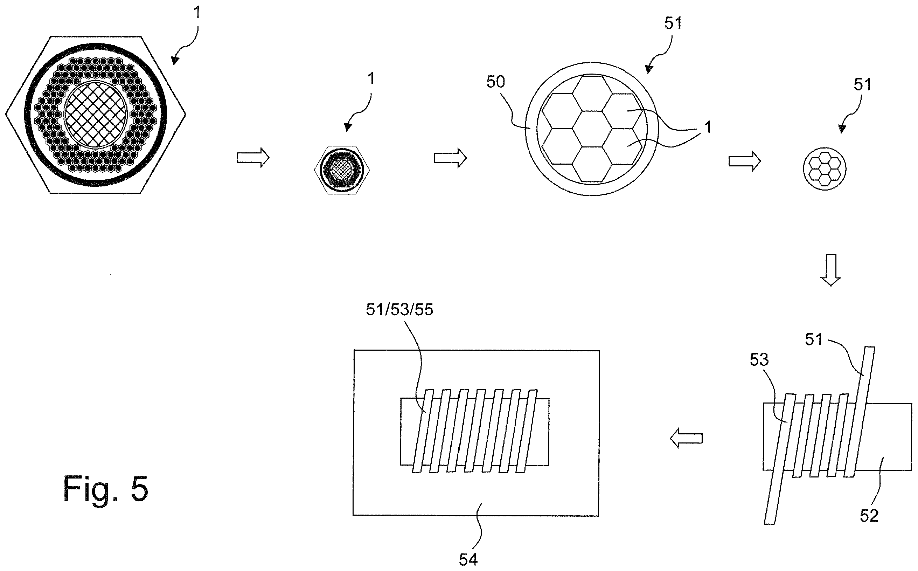

Das Subelement 1 kann zur Fertigung eines Nb₃Sn-haltigen Supraleiterdrahts eingesetzt werden, wobei typischerweise mehrere Subelemente 1 gezogen, gebündelt und in eine gewünschte Geometrie gebracht werden (vgl. Fig. 5 hierzu) und schließlich einer Reaktions-Wärmebehandlung unterzogen werden. Dabei reagiert das Sn aus dem Sn-haltigen Kern 3 vor allem mit dem Nb aus dem Bereich 7 der Nb-haltigen Stabelemente 8, wobei Nb₃Sn gebildet wird.

In der gezeigten Bauform beschleunigt das im Sn-haltigen Pulver 4 enthaltene Cu die Diffusion des Sn nach radial außen. Das Ti aus dem SnTi₂ und hier auch zu einem geringen Anteil aus dem Kernrohr 3 des Sn-haltigen Kerns 2 sorgt für die Bildung einer ternären Phase (enthaltend Nb, Sn und Ti), was die supraleitende Stromtragfähigkeit des fertigen Nb₃Sn-haltigen Supraleiterdrahts erhöht; zudem kann das Ti auch zur Beschleunigung der Diffusion des Sn nach radial außen beitragen. Weiterhin reagiert das Hf (als Legierungskomponente X) in den Nb-haltigen Kernfilamenten 9 mit dem Sauerstoff (als Partnerkomponente Pk) aus dem CuO im Sn-haltigen Pulver 4 zu Hf-Oxid-Partikeln (als Ausscheidungen XPk), die als Pinning-Zentren die Stromtragfähigkeit der Nb₃Sn-Phase erhöhen können.

Am Kernrohr 3, das hier mit einem hohen Nb-Gehalt gefertigt ist, bildet sich im Laufe der Reaktionswärmebehandlung eine Schicht von NbSn₂ aus, die in einer ersten Phase der Reaktions-Wärmebehandlung eine Diffusion von Sn nach radial weiter außen verzögert. In einer zweiten Phase der Reaktions-Wärmebehandlung bei höheren Temperaturen zerfällt das NbSn₂ zu Sn und Nb₃Sn, so dass radial nahe dem Bereich 7 der Nb-haltigen Stabelemente 8 Sn freigesetzt wird. Damit kann im vormaligen Bereich 7 der Nb-haltigen Stabelemente 8 ein sehr feines Gefüge von Nb₃Sn am Ende der Reaktions-Wärmebehandlung erhalten werden, das eine große supraleitende Stromtragfähigkeit besitzt. Zudem kann auch im Bereich des vormaligen Kernrohrs 3 bzw. dessen vormaliger Fläche Nb₃Sn erhalten werden.

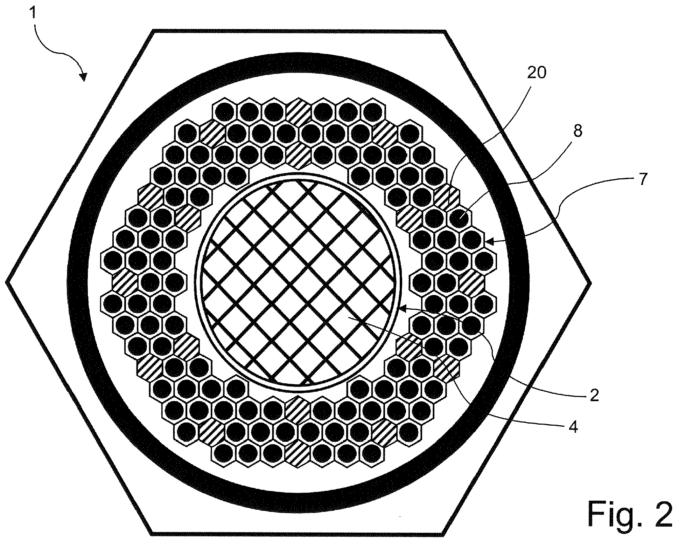

Die **Fig. 2** zeigt eine zweite Bauform eines e Subelements 1 ähnlich der ersten Bauform; es werden nur die wesentlichen Unterschiede im Folgenden erläutert. Das Subelement 1 kann im Rahmen des erfindungsgemäßen Verfahrens hergestellt werden.

Im Bereich 7 der Nb-haltigen Stabelemente 8 sind hier einige Zusatz-Stabelemente 20 unter die Nb-haltigen Stabelemente 8 (schraffiert dargestellt) untergemischt. Die Zusatz-Stabelemente 20 weisen ebenfalls eine hexagonale Kontur auf und haben die gleiche Größe wie die Nb-haltigen Stabelemente 8. Die Zusatz-Stabelemente 20 enthalten hier Nb und Ti, und bestehen hier entsprechend aus einer Legierung von Nb und Ti; zusätzlich kann auch noch Hf (als Legierungskomponente X) enthalten sein. Die Zusatz-Stabelemente 20 besitzen eine homogene (nicht strukturierte) Zusammensetzung. Dieses Ti ermöglicht wiederum die Bildung einer ternären Phase (aus Nb, Sn und Ti), wodurch die Stromtragfähigkeit des fertigen Nb₃Sn-Supraleiterdrahts verbessert wird. In diesem Fall ist es nicht nötig, die Pulvermischung des Sn-haltigen Pulvers 4 des Sn-haltigen Kerns 2 mit SnTi₂ zu versehen.

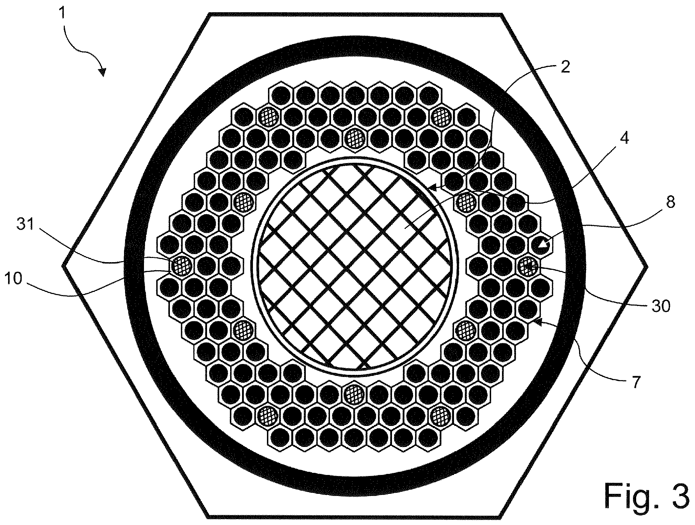

Die **Fig. 3** zeigt eine dritte Bauform eines Subelements 1 ähnlich der ersten Bauform; es werden wieder nur die wesentlichen Unterschiede im Folgenden erläutert. Das Subelement 1 kann im Rahmen des erfindungsgemäßen Verfahrens hergestellt werden.

Im Bereich 7 der Nb-haltigen Stabelemente 8, 30 sind hier einige Nb-haltige Stabelemente 30 mit einem Nb-haltigen Kernfilament 31 ausgebildet, das neben Nb auch Ti enthält. Entsprechend sind die Nb-haltigen Kernfilamente aus einer Legierung von Nb und Ti gefertigt; zusätzlich kann auch noch Hf (also Legierungskomponente X) enthalten sein. Dieses Ti ermöglicht wiederum die Bildung einer ternären Phase (aus Nb, Sn und Ti), wodurch die Stromtragfähigkeit des fertigen Nb₃Sn-Supraleiterdrahts verbessert wird. Auch in diesem Fall ist es nicht nötig, die Pulvermischung des Sn-haltigen Pulvers 4 des Sn-haltigen Kerns 2 mit SnTi₂ zu versehen.

Die **Fig. 4** erläutert in schematischen Teilbildern eine beispielhafte Variante der Herstellung eines Subelements 1.

Zur Fertigung des Subelements 1 wird zunächst in einem separaten Fertigungsprozess ein Zwischenkörper 40 bereitgestellt. Dieser umfasst eine hier einteilige, Cu-haltige Innenstruktur 41, die hier aus elementarem Cu gefertigt ist. Die Innenstruktur 41 kann außen rund oder profiliert (wie dargestellt) ausgebildet sein. Die Innenstruktur 41 ist von einem Ring von Nb-haltigen Stabelementen 8 umgeben. Um die Nb-haltigen Stabelemente 8 wird eine Cu-haltige Außenstruktur 42 angeordnet, die hier aus elementarem Cu gefertigt ist. Die Außenstruktur 42 kann innen rund oder profiliert (wie dargestellt) ausgebildet sein.

In der gezeigten Bauform umfasst der Zwischenkörper 40 auch eine Diffusionsbarriere 11, hier aus elementarem Nb, die um die Außenstruktur 42 angeordnet ist, sowie eine Hüllstruktur 12, hieraus elementarem Cu, die um die Diffusionsbarriere 11 angeordnet ist und hier eine hexagonale Außenform aufweist.

Der Zwischenkörper 40 wird sodann einer querschnittsreduzierenden Umformung unterzogen, etwa einem Extrudieren. Anschließend wird in die (querschnittsreduzierte) Innenstruktur 42 eine Ausnehmung (Durchbruch) 43, hier eine Bohrung, eingebracht. Der solchermaßen querschnittsreduzierte und gebohrte Zwischenkörper 40 wird auch als Hauptkörper 44 des Subelements 1 bezeichnet. Die vormalige Innenstruktur 41 entspricht dann der inneren Matrix 5, und die vormalige Außenstruktur 42 entspricht dann der äußeren Matrix 6.

Weiterhin wird in einem separaten Fertigungsprozess in ein Kernrohr 3, hier aus einer Legierung von Nb und Ti, ein Sn-haltiges Pulver 4 eingefüllt. Das solchermaßen befüllte Kernrohr 3 wird sodann einer querschnittsreduzierenden Umformung unterzogen, etwa durch Extrudieren. Dabei wird das Sn-haltige Pulver 4 verdichtet, nämlich im Wesentlichen radial verpresst. Dadurch wird der Sn-haltige Kern 2 für das Subelement 1 erhalten.

Der separat gefertigte Sn-haltige Kern 2 wird dann in die Ausnehmung 43 des separat gefertigten Hauptkörpers 44 eingesetzt, wodurch das vollständige Subelement 1 erhalten wird.

Man beachte, dass die Diffusionsbarriere 11 und die Hüllstruktur 12 alternativ auch nach dem Zusammenfügen von Hauptkörper 44 und Sn-haltigem Kern 2 am Subelement 1 angeordnet werden können (nicht näher dargestellt).

Die **Fig. 5** erläutert in schematischen Teilbildern sodann eine beispielhafte Variante der erfindungsgemäßen Herstellung eines Nb₃Sn-haltigen Supraleiterdrahts 55 auf Basis von Subelementen 1.

Ein wie beispielsweise in Fig. 4 gezeigt hergestelltes Subelement 1 (auch bezeichnet als Vorleiter) wird zunächst einer querschnittsverringernden Umformung, etwa einem Extrudieren, unterzogen. Sodann werden mehrere querschnittsreduzierte Subelemente 1 in einer Drahtaußenstruktur 50 gebündelt, wodurch eine Fertigleiter-Anordnung 51 erhalten wird. Das Bündeln ist aufgrund der hexagonalen Außenform der Subelemente 1 leicht möglich. Die Drahtaußenstruktur 50 kann innen rund (wie gezeigt) oder profiliert ausgebildet sein. Nach außen ist die Drahtaußenstruktur 50 hier rund ausgebildet; es sind aber auch andere Außenformen, etwa eine rechteckförmige Außenform, möglich. Anschließend wird die Fertigleiter-Anordnung 51 einer querschnittsreduzierenden Umformung, etwa einem Extrudieren, unterzogen.

Die umgeformte Fertigleiter-Anordnung 51 wird nun in eine gewünschte geometrische Form gebracht, und dazu in der gezeigten Variante beispielhaft auf einem Wickelkörper 52 zu einer Spule 53, hier einer Solenoidspule, gewickelt. Die gewickelte Fertigleiter-Anordnung 51 bzw. die Spule 53 wird dann in einen Ofen 54 verbracht, in welchem die Spule 53 erhitzt wird, typischerweise bis auf eine Maximaltemperatur zwischen 600°C und 800°C. Bei dieser Reaktions-Wärmebehandlung kommt es zur Bildung der supraleitenden Nb₃Sn-Phase in den in der Fertigleiter-Anordnung 51 enthaltenen Subelementen.

Durch die Reaktions-Wärmebehandlung wird die Fertigleiter-Anordnung 51 zum einsatzbereiten Nb₃Sn-haltigen Supraleiterdraht 55. Bei ausreichender Kühlung (etwa mit flüssigem Helium) nehmen die im Nb₃Sn-haltigen Supraleiterdraht 55 ausgebildeten Nb₃Sn-Filamente einen supraleitenden Zustand an, in welchem sie verlustfrei elektrischen Strom tragen können. Durch die Erfindung weist der Nb₃Sn-haltige Supraleiterdraht 55 eine besonders hohe Stromtragfähigkeit auf.

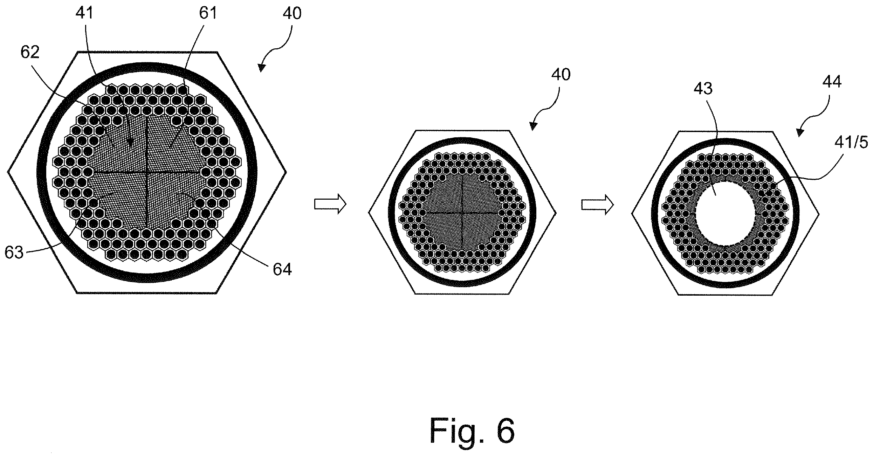

Die **Fig. 6** erläutert in schematischen Teilbildern eine Abwandlung der in Fig. 4 erläuterten Variante zur Herstellung eines Hauptkörpers 44 für ein Subelement. Es werden nur die wesentlichen Unterschiede zu Fig. 4 erläutert.

In der in Fig. 6 gezeigten Abwandlung besteht die nach außen profilierte Innenstruktur 41 aus vier Teilstücken 61, 62, 63, 64, die im wesentlichen sektorförmig ausgebildet sind und zusammen den Innenraum des Zwischenkörpers 40 bilden bzw. füllen. Dadurch kann die Fertigung der Innenstruktur 41 erleichtert werden. Man beachte, dass die Teilstücke 61-64 in der gezeigten Abwandlung identisch gebaut sind, und nur unterschiedlich orientiert und aneinander liegend angeordnet werden.

Nach der querschnittsreduzierenden Umformung des Zwischenkörpers 40 und Einbringung der Ausnehmung 43 wird ein Hauptkörper 44 erhalten, dessen innere Matrix 5 - entsprechend der mehrteiligen Innenstruktur 41 - ebenfalls mehrteilig ausgebildet ist; allerdings sitzen die Teile der Matrix 5 (insbesondere bedingt durch gegenseitige Abstützung) so fest im Hauptkörper 44, dass keine weiteren Haltemaßnahmen erforderlich sind, und der Hauptkörper 44 wie in Fig. 4 gezeigt weiter gehandhabt werden kann. Insbesondere kann in den Hauptkörper 44 wie in Fig. 4 dargestellt ein Sn-haltiger Kern eingesetzt werden, um ein Subelement zu erhalten.

### Bezugszeichenliste

- 1: Subelement
- 2: Sn-haltiger Kern
- 3: Kernrohr
- 4: Sn-haltiges Pulver / Pulverkern
- 5: innere Matrix
- 6: äußere Matrix
- 7: Bereich von Nb-haltigen Stabelementen
- 8: Nb-haltiges Stabelement
- 9: Nb-haltiges Kernfilament
- 10: Cu-haltige Filamenthülle
- 11: Diffusionsbarriere
- 12: Hüllstruktur
- 20: Zusatz-Stabelement
- 30: Nb-haltiges Stabelement, dessen Nb-haltiges Kernfilament einen Zusatzbestandteil enthält / Teil der Nb-haltigen Stabelemente
- 31: Kernfilament mit Zusatzbestandteil
- 40: Zwischenkörper
- 41: Innenstruktur
- 42: Außenstruktur
- 43: Ausnehmung / Durchbruch
- 44: Hauptkörper
- 50: Drahtaußenstruktur
- 51: Fertigleiter-Anordnung
- 52: Spulenkörper
- 53: Spule
- 54: Ofen
- 55: Nb₃Sn-haltiger Supraleiterdraht
- 61-64: Teilstücke Innenstruktur
- D: Durchmesser Kernrohr
- FA: Kleinster Abstand Nb-haltige Kernfilamente
- FD: Durchmesser Nb-haltige Kernfilamente
- GA: Größter Abstand
- WS: Wandstärke Kernrohr

## Patentansprüche

1. Verfahren zur Herstellung eines Subelement (1) für einen Nb₃Sn-haltigen Supraleiterdraht (55),
wobei das Subelement (1) ausgebildet ist mit
- einem Sn-haltigen Kern (2),
- einer inneren Matrix (5), die Cu enthält und die den Sn-haltigen Kern (2) umgibt,
- einen Bereich (7) von aneinander anliegenden Nb-haltigen Stabelementen (8, 30), der die innere Matrix (5) umgibt, wobei die Nb-haltigen Stabelemente (8, 30) jeweils mit einem Nb-haltigen Kernfilament (9; 31) und einer Cu-haltigen Filamenthülle (10) ausgebildet sind,
insbesondere wobei die Nb-haltigen Stabelemente (8, 30) jeweils im Außenquerschnitt hexagonal ausgebildet sind,
- einer äußeren Matrix (6), die Cu enthält und den Bereich (7) von Nb-haltigen Stabelementen (8, 30) umgibt,
**dadurch gekennzeichnet,**
**dass** der Sn-haltige Kern (2) separat gefertigt wird, mit den Schritten
a) in ein Kernrohr (3) wird ein Sn-haltiges Pulver (4) eingefüllt,
b) das Kernrohr (3) einschließlich des Sn-haltigen Pulvers (4) wird einer querschnittsreduzierenden Umformung unterzogen, wobei das Sn-haltige Pulver (4) des Sn-haltigen Kerns (2) verdichtet wird,
und **dass** der separat gefertigte Sn-haltige Kern (2) in eine Ausnehmung (43) der inneren Matrix (5) des Subelements (1) eingesetzt wird.

2. Verfahren nach Anspruch 1, **dadurch gekennzeichnet, dass** das Verfahren so geführt wird, dass im erhaltenen Subelement (1) für eine Wandstärke WS des Kernrohrs (3) und einen Durchmesser D des Kernrohrs (1) gilt: WS≤0,15^{∗}D, bevorzugt WS≤0,10^{∗}D.

3. Verfahren nach Anspruch 1 oder 2, **dadurch gekennzeichnet,**
**dass** das Sn-haltige Pulver (4) eine Pulvermischung ist, welche Sn in wenigstens zwei verschiedenen chemischen Formen enthält,
insbesondere wobei das Sn-haltige Pulver (4) Sn in wenigstens zwei der folgenden chemischen Formen enthält:
- elementares Sn,
- eine oder mehrere unterschiedlich zusammengesetzte intermetallische Phasen oder Legierungen von Nb und Sn, bevorzugt NbSn₂ und/oder Nb₆Sn₅,
- eine oder mehrere unterschiedlich zusammengesetzte intermetallische Phasen oder Legierungen von Cu und Sn,
- eine oder mehrere unterschiedlich zusammengesetzte intermetallische Phasen oder Legierungen von Sn und Ti;
- eine oder mehrere unterschiedlich zusammengesetzte intermetallische Phasen oder Legierungen von Sn und Ta.

4. Verfahren nach einem der vorhergehenden Ansprüche, **dadurch gekennzeichnet, dass** das Sn-haltige Pulver (4) eine Pulvermischung ist, welche einen Cu-haltigen Pulveranteil enthält,
insbesondere wobei der Cu-haltige Pulveranteil elementares Cu umfasst.

5. Verfahren nach einem der vorhergehenden Ansprüche, **dadurch gekennzeichnet, dass** das Kernrohr (3) Cu-haltig ist,
insbesondere mit wenigstens 25 Gew% Cu, bevorzugt mit wenigstens 50 Gew% Cu.

6. Verfahren nach einem der vorhergehenden Ansprüche, **dadurch gekennzeichnet, dass** das Kernrohr (3) Nb-haltig ist,
insbesondere mit wenigstens 50 Gew% Nb, bevorzugt mit wenigstens 75 Gew% Nb.

7. Verfahren nach einem der vorhergehenden Ansprüche, **dadurch gekennzeichnet, dass**
- zumindest ein Teil der Nb-haltigen Stabelemente (30) des Bereich (7) von aneinander anliegenden Nb-haltigen Stabelementen (8, 30) mit einem Nb-haltigen Kernfilament (31) ausgebildet ist, das zusätzlich zu Nb auch Ti, Ta, Hf und/oder Zr enthält, und/oder
- in den Bereich (7) von aneinander anliegenden Nb-haltigen Stabelementen (8, 30) Zusatz-Stabelemente (20) untergemischt sind, die Ti, Ta, Hf und/oder Zr enthalten.

8. Verfahren nach einem der vorhergehenden Ansprüche, **dadurch gekennzeichnet,**
**dass** das Sn-haltige Pulver (4) eine Pulvermischung ist, welche einen Pulveranteil enthält, der Ta-haltig und/oder Ti-haltig und/oder Hf-haltig und/oder Zr-haltig ist.

9. Verfahren nach einem der vorhergehenden Ansprüche, **dadurch gekennzeichnet,**
**dass** der Bereich (7) von aneinander anliegenden Nb-haltigen Stabelementen (8, 30) auch wenigstens eine Legierungskomponente X enthält, dass das Sn-haltige Pulver (4) auch wenigstens eine Partnerkomponente Pk enthält,
insbesondere wobei das Sn-haltige Pulver (4) eine Pulvermischung ist, welche einen Pulveranteil enthält, der die Partnerkomponente Pk enthält, und dass die Legierungskomponente X und die Partnerkomponente Pk so gewählt und angeordnet sind, dass sie bei einer ReaktionsWärmebehandlung des Subelements (1), bei dem Sn aus dem Sn-haltigen Kern (2) und Nb aus den Nb-haltigen Stabelementen (8, 30) zu Nb₃Sn reagieren, Ausscheidungen XPk bilden können.

10. Verfahren nach Anspruch 9, **dadurch gekennzeichnet, dass** die wenigstens eine Partnerkomponente Pk Sauerstoff umfasst.

11. Verfahren nach Anspruch 10, **dadurch gekennzeichnet, dass** das Sn-haltige Pulver (4) einen Pk-haltigen Pulveranteil enthält, wobei der Pk-haltige Pulveranteil ein Metalloxid umfasst, das durch die Legierungskomponente X reduziert werden kann,
insbesondere wobei das Metall des Metalloxids Sn, Cu, Zn, Nb, Fe, Ni, Cr, Co und/oder W umfasst und/oder das Metalloxid SnO₂, Cu₂O, CuO, ZnO, und/oder Nb₂O₅ umfasst.

12. Verfahren nach einem der Ansprüche 9 bis 11, **dadurch gekennzeichnet, dass** die Legierungskomponente X ein Metall umfasst, das unedler als Nb ist,
insbesondere wobei die Legierungskomponente X dabei Zr, AI, Ti, Hf und/oder Be umfasst.

13. Verfahren nach einem der Ansprüche 9 bis 12, **dadurch gekennzeichnet, dass** die Legierungskomponente X in den Nb-haltigen Kernfilamenten (9; 31) zumindest in einem Teil der Nb-haltigen Stabelemente (30) enthalten ist.

14. Verfahren nach einem der vorhergehenden Ansprüche, **dadurch gekennzeichnet, dass** das Subelement (1) weiterhin umfasst
- eine Diffusionsbarriere (11), die die äußere Matrix (6) umgibt, insbesondere wobei die Diffusionsbarriere (11) mindestens eines der Elemente Nb, Ta und/oder V enthält, und
- eine Hüllstruktur (12), die Cu enthält und die die Diffusionsbarriere (11) umgibt,
insbesondere wobei die Hüllstruktur (12) einen hexagonalen Außenquerschnitt aufweist.

15. Verfahren nach einem der vorhergehenden Ansprüche, **dadurch gekennzeichnet, dass** das Verfahren so geführt wird, dass im erhaltenen Subelement (1) für einen größten radialen Abstand GA zwischen dem Kernrohr (3) und der Innenseite des Bereichs der Nb-haltigen Stabelemente (8, 30) der inneren Matrix (5) und einen Durchmesser D des Kernrohrs (3) gilt: GA≤0,30^{∗}D, bevorzugt GA≤0,20^{∗}D, besonders bevorzugt GA≤0,10^{∗}D.

16. Verfahren nach einem der vorhergehenden Ansprüche, **dadurch gekennzeichnet, dass** das Verfahren so geführt wird, dass im erhaltenen Subelement (1) für einen kleinsten Abstand FA von Außenseite zu Außenseite zwischen den Nb-haltigen Kernfilamenten (9; 31) und einem Durchmesser FD der Nb-haltigen Kernfilamente (9; 31) gilt:
FA≤0,30^{∗}FD, bevorzugt FA≤0,20^{∗}FD, besonders bevorzugt FA≤0,15^{∗}FD, ganz besonders bevorzugt FA≤0,10^{∗}FD.

17. Verfahren nach einem der vorhergehenden Ansprüche, **dadurch gekennzeichnet,**
**dass** ein Hauptkörper (44) des Subelements (1), der die innere Matrix (5) mit der Ausnehmung (43), den Bereich (7) von aneinander anliegenden Nb-haltigen Stabelementen (8, 30) und die äußere Matrix (6) umfasst, separat gefertigt wird, mit den Schritten
a') um eine ein- oder mehrteilige Innenstruktur (41), die Cu enthält, werden die Nb-haltigen Stabelemente (8, 30) angeordnet, und um die Nb-haltigen Stabelemente (8, 30) wird mindestens eine Außenstruktur (42), die Cu enthält, angeordnet, wodurch ein Zwischenkörper (40) erhalten wird,
b') der Zwischenkörper (40) wird einer querschnittsreduzierenden Umformung unterzogen, und
c') in die querschnittsreduzierte Innenstruktur (41) wird eine Ausnehmung (43) eingebracht, wodurch die innere Matrix (5) mit der Ausnehmung (43) und insgesamt der Hauptkörper (44) erhalten wird.

18. Verfahren zur Herstellung eines Nb₃Sn-haltigen Supraleiterdrahts (55), umfassend folgende Schritte:
- mehrere Subelemente (1) werden nach einem der Ansprüche 1 bis 17 gefertigt;
- die gefertigten Subelemente (1) werden einer querschnittsreduzierenden Umformung unterzogen;
- die umgeformten Subelemente (1) werden zu einer Fertigleiter-Anordnung (51) gebündelt, wobei mehrere umgeformte Subelemente (1) aneinander gelegt werden und von einer Cu-haltigen Drahtaußenstruktur (50) umschlossen werden;
- die Fertigleiter-Anordnung (51) wird einer querschnittsreduzierenden Umformung unterzogen;
- die umgeformte Fertigleiter-Anordnung (51) wird in eine gewünschte geometrische Form gebracht, insbesondere zu einer Spule (53) gewickelt;
- die in Form gebrachte Fertigleiter-Anordnung (51) wird einer ReaktionsWärmebehandlung unterzogen, bei der das Nb und das Sn aus den Subelementen zu Nb₃Sn reagieren.

## Claims

1. A method for producing a subelement (1) for an Nb₃Sn-containing superconductor wire (55),
where the subelement (1) is configured with
- an Sn-containing core (2),
- an inner matrix (5) which comprises Cu and which surrounds the Sn-containing core (2),
- a region (7) of mutually abutting Nb-containing rod elements (8, 30), which surrounds the inner matrix (5), where the Nb-containing rod elements (8, 30) are each configured with an Nb-containing core filament (9; 31) and a Cu-containing filament casing (10),
more particularly where the Nb-containing rod elements (8, 30) are each configured hexagonally in external cross section,
- an outer matrix (6) which comprises Cu and surrounds the region (7) of Nb-containing rod elements (8, 30),
**characterized**
**in that** the Sn-containing core (2) is fabricated separately, with the steps of
a) introducing an Sn-containing powder (4) into a core tube (3),
b) reshaping the core tube (3) including the Sn-containing powder (4) with a reduction in cross section, where the Sn-containing powder (4) of the Sn-containing core (2) is compacted,
and **in that** the separately fabricated Sn-containing core (2) is inserted into a recess (43) in the inner matrix (5) of the subelement (1).

2. The method as claimed in claim 1, **characterized in that** the method is conducted such that in the resulting subelement (1) a wall thickness WS of the core tube (3) and a diameter D of the core tube (1) are subject to the following condition:
WS ≤ 0.15*D, preferably WS ≤ 0.10*D.

3. The method as claimed in claim 1 or 2, **characterized in that** the Sn-containing powder (4) is a powder mixture which comprises Sn in at least two different chemical forms,
more particularly where the Sn-containing powder (4) comprises Sn in at least two of the following chemical forms:
- elemental Sn,
- one or more differently composed intermetallic phases or alloys of Nb and Sn, preferably NbSn₂ and/or Nb₆Sn₅,
- one or more differently composed intermetallic phases or alloys of Cu and Sn,
- one or more differently composed intermetallic phases or alloys of Sn and Ti;
- one or more differently composed intermetallic phases or alloys of Sn and Ta.

4. The method as claimed in any of the preceding claims, **characterized in that** the Sn-containing powder (4) is a powder mixture which comprises a Cu-containing powder fraction,
more particularly where the Cu-containing powder fraction comprises elemental Cu.

5. The method as claimed in any of the preceding claims, **characterized in that** the core tube (3) is Cu-containing,
more particularly with at least 25 wt% of Cu, preferably with at least 50 wt% of Cu.

6. The method as claimed in any of the preceding claims, **characterized in that** the core tube (3) is Nb-containing,
more particularly with at least 50 wt% of Nb, preferably with at least 75 wt% of Nb.

7. The method as claimed in any of the preceding claims, **characterized in that**
- at least some of the Nb-containing rod elements (30) of the region (7) of mutually abutting Nb-containing rod elements (8, 30) are configured with an Nb-containing core filament (31) which as well as Nb also comprises Ti, Ta, Hf and/or Zr, and/or
- interspersed in the region (7) of mutually abutting Nb-containing rod elements (8, 30) are extra rod elements (20) which comprise Ti, Ta, Hf and/or Zr.

8. The method as claimed in any of the preceding claims, **characterized**
**in that** the Sn-containing powder (4) is a powder mixture which comprises a powder fraction which is Ta-containing and/or Ti-containing and/or Hf-containing and/or Zrcontaining.

9. The method as claimed in any of the preceding claims, **characterized**
**in that** the region (7) of mutually abutting Nb-containing rod elements (8, 30) also comprises at least one alloy component X,
**in that** the Sn-containing powder (4) also comprises at least one partner component Pk,
more particularly where the Sn-containing powder (4) is a powder mixture which comprises a powder fraction which comprises the partner component Pk,
and **in that** the alloy component X and the partner component Pk are selected and arranged in such a way that on reactive heat treatment of the subelement (1), wherein Sn from the Sn-containing core (2) and Nb from the Nb-containing rod elements (8, 30) react to give Nb₃Sn, precipitates XPk can form.

10. The method as claimed in claim 9, **characterized in that** the at least one partner component Pk comprises oxygen.

11. The method as claimed in claim 10, **characterized in that** the Sn-containing powder (4) comprises a Pk-containing powder fraction, where the Pk-containing powder fraction comprises a metal oxide which can be reduced by the alloy component X,
more particularly where the metal of the metal oxide comprises Sn, Cu, Zn, Nb, Fe, Ni, Cr, Co and/or W and/or the metal oxide comprises SnO₂, Cu₂O, CuO, ZnO, Ag₂O and/or Nb₂O₅.

12. The method as claimed in any of claims 9 to 11, **characterized in that** the alloy component X comprises a metal which is less noble than Nb,
more particularly where the alloy component X here comprises Zr, Al, Ti, Hf and/or Be.

13. The method as claimed in any of claims 9 to 12, **characterized in that** the alloy component X in the Nb-containing core filaments (9; 31) is present at least in some of the Nb-containing rod elements (30).

14. The method as claimed in any of the preceding claims, **characterized in that** the subelement (1) further comprises
- a diffusion barrier (11) which surrounds the outer matrix (6), more particularly where the diffusion barrier (11) comprises at least one of the elements Nb, Ta and/or V, and
- a casing structure (12) which comprises Cu and which surrounds the diffusion barrier (11),
more particularly where the casing structure (12) has a hexagonal external cross section.

15. The method as claimed in any of the preceding claims, **characterized in that** the method is conducted such that in the resulting subelement (1) a largest radial distance GA between the core tube (3) and the inside of the region of the Nb-containing rod elements (8, 30) of the inner matrix (5) and a diameter D of the core tube (3) are subject to the following condition:
GA ≤ 0.30*D, preferably GA ≤ 0.20*D, more preferably GA ≤ 0.10*D.

16. The method as claimed in any of the preceding claims, **characterized in that** the method is conducted such that in the resulting subelement (1) a smallest distance FA from outside to outside between the Nb-containing core filaments (9; 31) and a diameter FD of the Nb-containing core filaments (9; 31) are subject to the following condition:
FA ≤ 0.30*FD, preferably FA ≤ 0.20*FD, more preferably FA ≤ 0.15*FD, very preferably FA ≤ 0.10*FD.

17. The method as claimed in any of the preceding claims, **characterized**
**in that** a main body (44) of the subelement (1), which comprises the inner matrix (5) with the recess (43), the region (7) of mutually abutting Nb-containing rod elements (8, 30) and the outer matrix (6), is fabricated separately, with the steps of
a') arranging the Nb-containing rod elements (8, 30) around a one-part or multipart inner structure (41) which comprises Cu, and arranging at least one outer structure (42) which comprises Cu around the Nb-containing rod elements (8, 30), to give an intermediate body (40),
b') subjecting the intermediate body (40) to reshaping with a reduction in cross section, and
c') incorporating a recess (43) into the inner structure (41) with reduced cross section, to give the inner matrix (5) with the recess (43) and overall the main body (44).

18. A method for producing an Nb₃Sn-containing superconductor wire (55), comprising the following steps:
- fabricating a plurality of subelements (1) as claimed in any of claims 1 to 17;
- subjecting the fabricated subelements (1) to reshaping with reduction in cross section;
- bundling the reshaped subelements (1) to form a fabricated conductor arrangement (51), where a plurality of reshaped subelements (1) are placed against one another and enclosed by a Cu-containing outer wire structure (50);
- subjecting the fabricated conductor arrangement (51) to reshaping with reduction in cross section;
- bringing the reshaped fabricated conductor arrangement (51) into a desired geometric form, more particularly by winding to form a coil (53);
- subjecting the fabricated conductor arrangement (51), brought into form, to reactive heat treatment, wherein the Nb and the Sn from the subelements react to give Nb₃Sn.

## Revendications

1. Procédé pour la fabrication d'un sous-élément (1) pour un fil supraconducteur contenant du Nb₃Sn (55), le sous-élément (1) étant conçu avec
- un noyau contenant du Sn (2),
- une matrice interne (5) qui contient du Cu et qui entoure le noyau contenant du Sn (2),
- une zone (7) d'éléments formant tige contenant du Nb (8, 30), adjacents les uns aux autres, qui entoure la matrice interne (5), les éléments formant tige contenant du Nb (8, 30) étant à chaque fois conçus avec un filament central contenant du Nb (9, 31) et une enveloppe de filament contenant du Cu (10), la section transversale externe des éléments formant tige contenant du Nb (8, 30) étant en particulier à chaque fois conçue de manière hexagonale,
- une matrice externe (6), qui contient du Cu et qui entoure la zone (7) d'éléments formant tige contenant du Nb (8, 30),
**caractérisé en ce que** le noyau contenant du Sn (2) est fabriqué séparément par les étapes
a) une poudre contenant du Sn (4) est introduite dans un tube central (3),
b) le tube central (3) contenant la poudre contenant du Sn (4) est soumis à un façonnage réduisant la section, la poudre contenant du Sn (4) du noyau contenant du Sn (2) étant compactée,
et **en ce que** le noyau contenant du Sn (2) fabriqué séparément est introduit dans un évidement (43) de la matrice interne (5) du sous-élément (1).

2. Procédé selon la revendication 1, **caractérisé en ce que** le procédé est exécuté de manière telle que la relation suivante est d'application dans le sous-élément (1) obtenu, pour une épaisseur de paroi WS du tube central (3) et un diamètre D du tube central (1) : WS ≤ 0,15 * D, de préférence WS ≤ 0,10 * D.

3. Procédé selon la revendication 1 ou 2, **caractérisé en ce que** la poudre contenant du Sn (4) est un mélange de poudre qui contient du Sn sous au moins deux formes chimiques différentes, la poudre contenant du Sn (4) contenant en particulier du Sn sous au moins deux des formes chimiques suivantes :
- Sn élémentaire,
- un(e) ou plusieurs phases ou alliages intermétalliques de Nd et de Sn de compositions différentes, de préférence du NbSn₂ et/ou du Nb₆Sn₅,
- un(e) ou plusieurs phases ou alliages intermétalliques de Cu et de Sn de compositions différentes,
- un(e) ou plusieurs phases ou alliages intermétalliques de Sn et de Ti de compositions différentes,
- un(e) ou plusieurs phases ou alliages intermétalliques de Sn et de Ta de compositions différentes.

4. Procédé selon l'une quelconque des revendications précédentes, **caractérisé en ce que** la poudre contenant du Sn (4) est un mélange de poudre qui contient une proportion de poudre contenant du Cu, la proportion de poudre contenant du Cu comprenant en particulier du Cu élémentaire.

5. Procédé selon l'une quelconque des revendications précédentes, **caractérisé en ce que** le tube central (3) contient du Cu, en particulier au moins 25% en poids de Cu, de préférence au moins 50% en poids de Cu.

6. Procédé selon l'une quelconque des revendications précédentes, **caractérisé en ce que** le tube central (3) contient du Nb, en particulier au moins 50% en poids de Nb, de préférence au moins 75% en poids de Nb.

7. Procédé selon l'une quelconque des revendications précédentes, **caractérisé en ce que**
- au moins une partie de l'élément formant tige contenant du Nb (30) de la zone (7) d'éléments formant tige contenant du Nb (8, 30) adjacents les uns aux autres est conçue avec un filament central contenant du Nb (31), qui contient en plus du Nb également du Ti, du Ta, de l'Hf et/ou du Zr et/ou
- des éléments formant tige (20) supplémentaires, qui contiennent du Ti, du Ta, de l'Hf et/ou du Zr, sont mélangés dans la zone (7) d'éléments formant tige contenant du Nb (8, 30) adjacents les uns aux autres.

8. Procédé selon l'une quelconque des revendications précédentes, **caractérisé en ce que** la poudre contenant du Sn (4) est un mélange de poudre, qui contient une proportion de poudre qui contient du Ta et/ou du Ti et/ou de l'Hf et/ou du Zr.

9. Procédé selon l'une quelconque des revendications précédentes, **caractérisé en ce que** la zone (7) d'éléments formant tige contenant du Nb (8, 30) adjacents les uns aux autres contient également au moins un composant d'alliage X, **en ce que** la poudre contenant du Sn (4) contient également au moins un composant partenaire Pk,
en particulier la poudre contenant du Sn (4) étant un mélange de poudre qui contient une proportion de poudre qui contient le composant partenaire Pk et **en ce que** le composant d'alliage X et le composant partenaire Pk sont choisis et agencés de manière telle qu'ils peuvent former, lors d'un traitement thermique réactionnel du sous-élément (1), lors duquel le Sn du noyau contenant du Sn (2) et le Nb des éléments formant tige contenant du Nb (8, 30) réagissent en Nb₃Sn, des dépôts de XPk.

10. Procédé selon la revendication 9, **caractérisé en ce que** ledit au moins un composant partenaire Pk comprend de l'oxygène.

11. Procédé selon la revendication 10, **caractérisé en ce que** la poudre contenant du Sn (4) contient une proportion de poudre contenant le Pk, la poudre contenant le Pk comprenant un oxyde métallique qui peut être réduit par le composant d'alliage X, le métal de l'oxyde métallique comprenant en particulier du Sn, du Cu, du Zn, du Nb, du Fe, du Ni, du Cr, du Co et/ou du W et/ou l'oxyde métallique comprenant en particulier du SnO₂, du Cu₂O, du CuO, du ZnO, du Ag₂O et/ou du Nb₂O₅.

12. Procédé selon l'une quelconque des revendications 9 à 11, **caractérisé en ce que** le composant d'alliage X comprend un métal qui est moins noble que le Nb, le composant d'alliage X comprenant en particulier du Zr, de l'Al, du Ti, de l'Hf et/ou du Be.

13. Procédé selon l'une quelconque des revendications 9 à 12, **caractérisé en ce que** le composant d'alliage X dans les filaments centraux contenant du Nb (9 ; 31) est contenu dans au moins une partie des éléments formant tige contenant du Nb (30).

14. Procédé selon l'une quelconque des revendications précédentes, **caractérisé en ce que** le sous-élément (1) comprend en outre
- une barrière de diffusion (11), qui entoure la matrice externe (6), la barrière de diffusion (11) contenant en particulier au moins l'un des éléments Nb, Ta et/ou V, et
- une structure enveloppante (12), qui contient du Cu et qui entoure la barrière de diffusion (11), la structure enveloppante (12) présentant en particulier une section transversale externe hexagonale.

15. Procédé selon l'une quelconque des revendications précédentes, **caractérisé en ce que** le procédé est exécuté de manière telle que dans le sous-élément (1) obtenu, la relation suivante est d'application pour la distance radiale la plus grande GA entre le tube central (3) et la face interne de la zone des sous-éléments formant tige contenant du Nd (8, 30) de la matrice interne (5) et pour un diamètre D du tube central (3) : GA ≤ 0,30 * D, de préférence GA ≤ 0,20 * D, de manière particulièrement préférée GA ≤ 0,10 * D.

16. Procédé selon l'une quelconque des revendications précédentes, **caractérisé en ce que** le procédé est exécuté de manière telle que dans le sous-élément (1) obtenu, la relation suivante est d'application pour la distance radiale la plus petite FA de face externe à face externe entre les filaments centraux contenant du Nb (9 ; 31) et pour un diamètre FD des filaments centraux contenant du Nb (9 ; 31) : FA ≤ 0,30 * FD, de préférence FA ≤ 0,20 * FD, de manière particulièrement préférée FA ≤ 0,15 * FD, de manière tout particulièrement préférée FA ≤ 0,10 * FD.

17. Procédé selon l'une quelconque des revendications précédentes, **caractérisé**
**en ce qu'**un corps principal (44) du sous-élément (1), qui comprend la matrice interne (5) pourvue de l'évidement (43), la zone (7) d'éléments formant tige contenant du Nb (8, 30) adjacents les uns aux autres et la matrice externe (6), est fabriqué séparément par les étapes
a') les éléments formant tige contenant du Nb (8, 30) sont agencés autour d'une structure interne (41) en une ou plusieurs parties, qui contient du Cu, et au moins une structure externe (42) qui contient du Cu, est agencée autour des éléments formant tige contenant du Nb (8, 30), suite à quoi un corps intermédiaire (40) est obtenu,
b') le corps intermédiaire (40) est soumis à un façonnage réduisant la section transversale et
c') un évidement (43) est réalisé dans la structure interne à section transversale réduite (41), suite à quoi on obtient la matrice interne (5) pourvue de l'évidement (43) et, au total, le corps principal (44) .

18. Procédé pour la fabrication d'un fil supraconducteur contenant du Nb₃Sn (55), comprenant les étapes suivantes :
- plusieurs sous-éléments (1) sont fabriqués selon l'une quelconque des revendications 1 à 17 ;
- les sous-éléments (1) fabriqués sont soumis à un façonnage réduisant la section transversale ;
- les sous-éléments (1) façonnés sont rassemblés en un agencement de conducteur fini (51), plusieurs sous-éléments (1) façonnés étant placés les uns contre les autres et entourés par une structure externe de fil contenant du Cu (50) ;
- l'agencement de conducteur fini (51) est soumis à un façonnage réduisant la section transversale ;
- l'agencement de conducteur fini (51) façonné est amené dans la forme géométrique souhaitée, en particulier enroulé en une bobine (53) ;
- l'agencement de conducteur fini (51) amené dans la forme est soumis à un traitement thermique réactionnel, lors duquel le Nb et le Sn des sous-éléments réagissent en Nb₃Sn.
